Europäisches Patentamt

European Patent Office

Office européen des brevets

(19)

(11) Publication number: **0 117 013**
A2

# (12) EUROPEAN PATENT APPLICATION

(21) Application number: **84300011.8**

(22) Date of filing: **03.01.84**

(51) Int. Cl.³: **G 03 C 5/00**

(30) Priority: **04.01.83 US 464131**

(43) Date of publication of application:
**29.08.84 Bulletin 84/35**

(84) Designated Contracting States:
**AT BE CH DE FR GB IT LI SE**

(71) Applicant: **Sage Technology, Inc.**
**10960 Via Frontera**
**San Diego California 92127(US)**

(72) Inventor: **Hallman, Robert W.**
**16458 Bronco Lane**
**Poway California 92064(US)**

(72) Inventor: **Langlais, Eugene L.**
**17619 Cabela Drive**
**San Diego California 92127(US)**

(72) Inventor: **Warner, Patrick G.**
**1427 Kenora Street**
**Escondido California 92027(US)**

(74) Representative: **Wilson, Nicholas Martin et al,**
**WITHERS & ROGERS 4 Dyer's Buildings Holborn**
**London EC1N 2JT(GB)**

(54) Additive film and method.

(57) The additive film and photographic method for forming a hard gradation, maximum density image on such film involve association of a photoactive coating of a nitrogen-containing compound on a transparent supporting film base of which the surface is hydrophilic and oleophobic. Image formation on this film is effected by exposing the surface carrying the nitrogen-containing compound to ultraviolet light through an image-bearing master and treating the exposed coating with an image-developing emulsion.

EP 0 117 013 A2

ADDITIVE FILM AND METHOD

FIELD OF THE INVENTION

This invention relates to a light-sensitive additive processing method and film.

BACKGROUND OF THE INVENTION

Light-sensitive printing material with a hard gradation and a high maximum density, usually referred to as lith film, is used particularly for making intermediates in the manufacture of printing devices such as planographic printing plates. Lith films are used, for example, to prepare a positive intermediate from a negative transparent halftone of a continuous tone original, or to prepare a number of negative copies, or parts of such copies which have a different transparency to light or density to provide a single positive intermediate of uniform transparency and density.

For use in preparing printing plates, proofs, engineering draftable second originals, photo templates for electronics and other special uses, previously known photographic film systems have been lacking in various respects. Silver halide film systems require handling in the dark and for extremely fine detail work, the dimensions of the silver grains which constitute the light-blocking factor in such films may interfere with precise definition. Systems based on other metal halides or other metal salt may present the same difficulties.

Non-silver halide photo reproduction systems are increasingly important, not only because of the higher cost of silver, but for many areas where permanence, sharpness and special requirements are not fully satisfied by silver halide images.

Diazo compounds and particularly diazonium compounds have been found to act as photosensitive agents for photopolymerization processes. Diazo compounds have the ability to combine with aromatic amines, phenols, phenol ethers or aliphatic compounds containing active methylene groups to form colored compounds known as azo dyes; and decomposition of such compounds by ultraviolet light to products incapable of coupling to form a dye has been used in diazotype processes to form photocopies. These processes in general require maintenance of acid conditions to prevent dye formation prior to exposure and an alkaline treatment to induce coupling and color development after exposure.

Diazo compounds such as diazo-formaldehyde condensates have also been associated with soluble organic colloids, such as gelatine, dextrine, gum arabic, polyvinyl alcohol, methyl cellulose and polyamides coated on aluminum plates to form pre-sensitized printing plates. In the making of photo-lithographic printing plates, portions exposed to ultraviolet light around an opaque image become insoluble and the image is developed by washing away the still soluble unexposed areas. The insoluble material of the image becomes oleophilic and capable of retaining greasy ink as used in photomechanical printing processes. However, to insure hydrophilic properties in the non-image areas, it is necessary to anodize the surfaces of the aluminum plate or to treat it with sodium silicate.

It has also been found that photolytic products of some diazonium compounds, especially of diazotized p-phenylene diamine condensates with formaldehyde or a phenol formaldehyde, are in themselves capable of retaining greasy ink. With these, however, to avoid reaction of the diazonium salt with the metal of the aluminum plate, the plate is coated with various compounds providing a permanently hydrophilic siliceous surface prior to sensitizing.

BRIEF STATEMENT OF THE INVENTION

The additive film and photographic method for forming a hard gradation, maximum density image on such film involve association of a photoactive coating of a nitrogen-containing compound on a transparent supporting film base of which the surface is hydrophilic and oleophobic. Image formation on this film is effected by imagewise exposing the surface carrying the nitrogen-containing compound to ultraviolet light and treating the coating with an agent to develop the image and deposit a pigment or dye.

DETAILED DESCRIPTION OF THE INVENTION

Supporting film bases for association with a coating of photoactive nitrogen-containing compounds for use in the present image-forming method and article will have a dimensionally stable, transparent base sheet of a resin such as a polyester resin or polyethylene, polyethylene terephthalate, polycarbonate and the like, having a hydrophilic and oleophobic, preferably matte having a hydrophilic and oleophobic matte surface stratum. The terms "hydrophilic" and "oleophobic" in the specification and claims refers to the property of the surface to accept and resist aqueous and oil-base components respectively of the image developer. Commercially available films suitable for film subbing or wet erasable drafting, for example, "Crovex" (a product of DuPont) and "Folarex Type H" (a product of Folex) matte films have been found suitable. Such films may provide the desired surface through coatings on the resin base sheet deposited from solutions of hydrophilic materials such as gelatine, polyvinyl alcohol, polyvinylpyrrolidone, polyacrylic acid, hydrolyzed starch, gum arabic, gum tragacanth and similar materials. Silica, either finely divided crystalline or amorphous type, is included in the coating to provide the matte surface.

In this application, the terms photoactive "diazonium", "diazo" and "diazo resin" are used to include not only the ordinary photoactive diazo compounds and resins known to the art for use in lithography such as the diazo compounds N-(4-diazo 2, 5 diethoxyphenyl) morpholine zinc chloride salt, N-(4-diazo 2, 5 dibutoxyphenyl) morpholine zinc chloride salt, 4-diazo diphenylamine bisulfate, 4-diazo 2, 5 diethoxy (4-tolylmercapto) benzene zinc chloride salt, 4-diazo-3-methoxy-diphenylamine sulfate and the diazo resins 4-diazo diphenylamine bisulfate condensation product with paraformaldehyde or formaldehyde as the zinc chloride salt, but also all photopolymerizable materials of which the photoactive properties are derived from a diazo component. For example, the term "diazo" is intended to include the reaction product of certain coupling agents and diazo compounds as disclosed in U. S. Patent to Chu, 3,300,309 and diazo reaction products with potassium ferrocyanide as disclosed in U. S. Patent to Mellan, 3,113,023.

Also, the term "photoactive nitrogen-containing compound", is used to include not only the diazo and diazonium compounds discussed above, but also photoactive azides, aromatic azido resins and aliphatic azido resins described on page 29 of "The Aromatic Diazo Compounds" by H. K. Saunders, published 1949, by Edward Arnold & Company of London; or monomolecular imino-quinone diazides; ortho quinone diazides and their esters or amides as disclosed on pages 339-352 of "Light Sensitive Systems" by Kosar, published 1965 by John Wiley & Sons; p-tertiary amino diazo resins; and photoactive diazo resins or resin forming compounds of the type described in U. S. Patent to Jewett et al, 2,714,066.

The photoactive nitrogen-containing compounds such as diazonium salts or diazo resins are applied to the supporting film base in solutions which may contain additives, such as citric acid, oxalic acid and thiourea, known to those skilled in the art to stabilize and increase the shelf life of the compounds. Other additives, such as wetting agents, polyvinyl alcohol, polyvinylpyrrolidone, polyacrylic acid, gelatine and surfactants may be used to improve wetting, coatability, film formation and adhesion. The concentration of photoactive compound in the coating solution may vary widely from as little as 0.2% by weight of the compound up to a saturated solution. Water is the usual solvent, but other volatile solvents such as methyl alcohol, methyl cellosolve and methyl ethyl ketone or mixtures of water and other solvents may be used.

The solution of photoactive compound may be applied to the matte surface of the film by any suitable procedure for forming a thin uniform deposit, as by wiping on with an absorbent paper wipe carrying the solution or by dipping or roller coating. The coating is then dried. The resulting coated film is stable over substantial periods and is not materially affected by limited exposure to room lighting.

To form an image on the film it is exposed to ultraviolet light in association with an image forming master which provides exposed and unexposed areas on the film. Any ultraviolet light source providing radiation in the range to which the photosensitive compound is responsive, typically 350 to 400 nm., may be used such as fluorescent bulbs, xenon or mercury vapor lamps, laser sources, sunlight or even room light. Exposure is continued for a time dependent on the photosensitivity of the deposit and the intensity of radiation to change the solubility characteristics of the exposed areas of the film surface. This may be conversion of the exposed areas to insoluble state leaving the unexposed areas soluble, or conversion of the exposed areas to a state soluble in a selected solvent in which the unexposed areas are insoluble.

Development of the image on the exposed coated film is effected through application of an oil in water developer emulsion. These developers are aqueous emulsions in which the dispersed oil phase may contain pigments or dyes dissolved or dispersed in a liquid binder material which is usually a resin dissolved in a solvent or solvent blend. The aqueous phase of the emulsion preferably contains hydrophilic agents such as gum arabic and the like and surfactants which assist in preventing deposition of the pigment or dye or binder in non-exposed non-image areas. Commercial emulsions of the type manufactured for processing of lithographic plates, for example, "Western Litho - Black Diamond", "Sage Imagefixe", "Richardson Astro Black", Western Litho PN", "Lith Kem Co. Rub-Up Ink", and "Asphaltum - Gum", can be used in the present process to form images. However, special developer emulsions formulated solely for the purpose of depositing image forming pigment or dye on exposed areas of the present film are useful since it is not necessary to impart lithographic printing properties to the film although it is possible to do so. These special developer emulsions may be formulated in any color so that the additive films can be used as articles of color proofing or for multicolored renditions, such as used by architects or to simulate multi-layered circuit patterns or for a plurality of other uses.

The developer emulsion is spread on the exposed surface and lightly rubbed, for example, with a wet sponge. Portions of the film which were exposed to ultraviolet light show up within seconds through fixing of the binder and pigment or dye of the emulsion on the exposed irradiated surface which has become oleophilic, while deposited photoactive compound on the unexposed surface is dissolved and removed by the emulsion. A fully developed image of reverse polarity to the image forming master is formed, usually in about thirty seconds and the film is then rinsed with water and dried, for example, by squeegee action.

0117013

The resulting image bearing film is ready for use at this stage and has been found to provide a high contrast image and superior accuracy of reproduction of the master image, particularly in fine detail. Lines and spaces as small as 15 microns have consistently been produced. An optical density in the exposed area ranging from 1 to 4 depending on the developer chosen and virtually unchanged minimum density in the unexposed areas are obtained.

This system has been found to work with broad performance latitudes in exposure and development. Additionally, a developed film can be recoated locally or completely, re-exposed and redeveloped to effect an add-on image capability. Samples have been prepared where the cycle has been repeated up to 5 times without degradation. Still further aspects of the system include the use of different color developers to provide spot color for emphasis. In the case of a developer system designed to provide a hydrophilic image via drying or post treatment, it is then possible to provide a surprint color proofing system.

The following examples are given to aid in understanding the invention but it is to be understood that the invention is not limited to the particular materials, proportions or other details of the examples.

Example 1.

A photoactive coating solution comprising 14 grams of a commercial water soluble condensation product of a diazo compound with paraformaldehyde, ("Diazo #4" obtained from the Fairmount Chemical co.), 500 grams of water and 3 grams of alkylphenoxy polyethoxy ethanol wetting agent was prepared by adding the wetting agent to the water, stirring for several minutes, then adding the diazo compound and continuing to stir until a clear solution was obtained.

An 0.004 inch thick eight and one-half by eleven inch sheet of a commercial polyester base drafting film having a hydrophilic matte surface layer ("DuPont Crovex Matte drafting film"), was coated with the solution by wiping on 2ml. of the solution with a paper wipe. While most of the coating was in fact absorbed into the wipe, enough adhered to the sheet to give a uniform pale yellow appearance. The coated sheet was then dried by forced air at room temperature for two minutes to form a photoactive film.

The film was then placed in intimate contact with a film negative in a vacuum frame and exposed to a 4 kw. mercury vapor ultraviolet light source at a distance of about 24 inches for 10 seconds.

An oil-in-water emulsion in which the dispersed phase was a solution of a black pigment in a lacquer vehicle was then applied to the photoactive surface of the exposed film and lightly rubbed with a sponge. A black image appeared seconds after the rubbing began and at the end of thirty seconds, a fully developed image of reverse polarity to the film negative was produced. The sheet was then rinsed in tap water and dried by squeegee action for inspection and use.

Example 2.

Using the coating solution of Example 1, sheets of matte films, Folarex Type H and Folarex Type D were coated, dried and exposed as in Example 1. The Type H film had a hydrophilic-oleophobic surface while the Type D film and an oleophilic surface as shown by wiping the original unexposed surfaces of samples of the two films with the oil-in-water emulsion of Example 1. Upon development using the materials and methods of Example 1, the Type H sample resulted in a high quality film image of reverse polarity relative to the master, while the Type D sample showed blackened areas on both exposed and unexposed portions, yielding a very poor reproduction.

Example 3.

Using the film having the developed image on the Type H Folex produced in Example 2, the film was recoated with the photoactive coating solution of Example 1 and dried. A new master film negative was placed over this film, and the assembly was re-exposed and developed a second time. The result was a new image superimposed over the first image. This add-on method was used to produce 5 cycles of new images without damaging the first image.

Example 4.

A photoactive coating solution comprising 10 grams of a diazo compound (Diazo Resin BBP of Molecular Rearrangement Inc., a p-diazo diphenylamine sulfate condensate with paraformaldehyde stabilized with hexafluoro phosphoric acid) and a solvent mixture of 90 grams of methyl cellosolve and 10 grams of dimethyl formamide is prepared by dissolving the diazo compound with stirring in the solvent mixture until a clear solution is obtained.

The solution is then roller coated onto the polyester film base of Example 1 and dried with forced air at room temperature for one minute to form a photoactive coating.

The resulting film is exposed as in Example 1. Subsequent to exposure the film is treated with a solution consisting of eight grams of sodium lauryl sulfate, twenty grams of butyl cellosolve and 90 grams of water to remove the unexposed coating.

While still wet, the film is sequentially treated with a lacquer emulsion ("R" Lacquer of the 3M Company). Thirty seconds after rubbing with a sponge, a red image appears. The processed film is then rinsed, dried and inspected.

A second sheet of the same film base is coated with the same diazo coating solution, exposed, treated with the developer solution and then treated with a lacquer emulsion (Image-Fixe of SAGE Technology Inc.). A black image appears after thirty seconds and the sheet is then rinsed, dried and inspected.

Example 5.

A photoactive coating solution comprising ten grams of an ortho-quinone diazide ester (Diazo Resin LL of Molecular Rearrangement Inc.), ten grams of Novolak 1280 of Union Carbide and a solvent mixture of 80 grams of methyl ethyl ketone and 20 grams of methyl cellosolve is prepared by dissolving the novolak resin in the solvent mixture until the solution is clear and then adding ortho-quinone-diazide ester and stirring until completely dissolved.

This solution is then roller coated onto the polyester film base of Example 1 and is dried by baking in an oven for three minutes at 300°F.

The resulting film is exposed as in Example 1. Subsequent to exposure, the film is treated with a solution consisting of 6 grams of trisodium phosphate, 1 gram of sodium lauryl sulfate and 100 grams of water to remove the exposed coating.

While still wet, the film is sequentially treated with a lacquer emulsion (Image-Fixe of Sage Technology, Inc.).

After thirty seconds of rubbing with a sponge, a black image appears. The film is then rinsed, dried and inspected.

In the film and process of the invention the photoactive compound is preferably a diazonium compound, or a diazo aldehyde resin or an orthoquinone azide.

CLAIMS

1.  The additive film process comprising the steps of imagewise exposure of a transparent supporting base sheet, a hydrophilic-oleophobic surface on said base sheet and a coating containing a photoactive, solvent or water soluble nitrogen-containing compound on said surface, to ultraviolet light for a length of time and intensity to change the solubility characteristics of said photoactive compound in areas of said composite to which light is transmitted, treating said composite to remove said coating from areas in which said coating is soluble and to deposit a binder and pigment or dye on remaining insoluble areas of coating to form an image.

2.  A process as defined in Claim 1 in which said treatment is effected in a single step using an oil-in-water developer emulsion in which the dispersed non-aqueous phase includes a binder and a pigment or dye.

3.  A process as defined in Claim 1 in which said treatment comprises first the removal of the coating from soluble areas and a separate treatment to deposit a binder and pigment or dye on said insoluble areas.

4.  A process as defined in Claim 1 in which said base sheet comprises a dimensionally stable water insoluble resin supporting film carrying a surface stratum of a material which is oleophobic relative to the non-volatile components of the dispersed phase of a selected oil-in-water developer emulsion and which contains dispersed finely divided silica providing a matte surface to said stratum.

5. A process as defined in Claim 4 in which said photoactive compound is a member of the class consisting of diazo compounds, diazonium compounds, azides, aromatic azido resins, aliphatic azido resins, imino-quinone diazides, orthoquinone azides, p-tertiary amino diazo resins, and diazo aldehyde resin.

6. A process as defined in Claim 5 in which the binder component of said dispersed phase of the developer comprises a resin carried in a water-insoluble volatile solvent.

7. A process as defined in Claim 5 in which said coating contains an additive for stabilizing said photoactive compound.

8. A process as defined in Claim 7 in which said coating contains at least one agent for improving its physical properties selected from the group consisting of polyvinyl alcohol, polyvinyl pyrrolidone, polyacrylic acid, gelatin and surfactants.

9. A process as defined in Claim 8 in which the resin of said supporting film is polyethylene terephthalate and said surface stratum is a member of the group consisting of gelatin, polyvinyl alcohol, polyvinylpyrrolidone, polyacrylic acid, hydrolyzed starch, gum arabic and gum tragacanth.

10. A process as defined in Claim 1 in which a further coating of photoactive nitrogen-containing compound is applied over the image-bearing surface of said film, said film is assembled with a further image bearing master, said assembly is exposed to ultraviolet light to convert portions of said further coating to which light is transmitted through said further master to a hydrophilic-oleophobic state and said film is then treated with an oil-in-water developer emulsion to deposit binder and pigment or dye on portions of said further coating so converted and to. remove said further coating from areas to which light was not transmitted.

11. A process as defined in Claim 10 in which said further coating is applied to an area less than the complete area of said film.

12. A process as defined in Claim 10 in which an area less than the complete area of said film is exposed to ultraviolet light.

13. A process as defined in Claim 1 in which exposed areas of said photoactive compound are converted to insoluble state by said ultraviolet light and coating is removed from unexposed areas.

14. A process as defined in Claim 1 in which exposed areas of said photoactive compound are converted to a state soluble in a solvent in which unexposed areas are insoluble and said solvent is applied to remove coating from said exposed areas.

15. An additive film comprising a composite of a transparent supporting base sheet having a surface which is oleophobic relative to the non-volatile components of the dispersed phase of a selected oil-in-water developer emulsion and a coating on said surface containing a photoactive nitrogen-containing compound.

16. An additive film as defined in Claim 15 in which said base sheet comprises a dimensionally stable water-insoluble resin supporting film and a surface stratum of hydrophilic-oleophobic material containing dispersed finely divided silica providing a matte surface to said stratum.

17. An additive film as defined in Claim 16 in which said photoactive compound is a member of the group consisting of diazo compounds, diazonium compounds, azides, aromatic azido resins, aliphatic azido resins, imino-quinone diazides, orthoquinone azides, p-tertiary amino diazo resins, and diazo aldehyde resin.

18. An additive film as defined in Claim 17 in which said coating contains an additive for stabilizing said photoactive compound.

19. An additive film as defined in Claim 17 in which said coating contains at least one agent for improving its physical properties selected from the group consisting of polyvinyl alcohol, polyvinylpyrrolidone, polyacrylic acid, gelatin and surfactants.

20. An additive film as defined in Claim 17 in which the resin of said supporting film is polyethylene terephthalate and said surface stratum comprises at least one member of the group consisting of gelatin, polyvinyl alcohol, polyvinylpyrrolidone, polyacrylic acid, hydrolyzed starch, gum arabic and gum tragacanth.

21. A photo reproduction film comprising a composite of a transparent supporting base sheet, a hydrophilic-oleophobic surface on said base sheet and an image on portions of said surface comprising a nitrogen-containing compound and a coating of pigment or dye fixed in a binder adhered to said image.

22. A photo reproduction film as defined in Claim 21 in which said nitrogen-containing compound is a member of the group consisting of diazo compounds, diazonium compounds, azides, aromatic azido resins, aliphatic azido resins, imino-quinone diazides, orthoquinone azides, p-tertiary amino diazo resins, and diazo aldehyde resin.